Europäisches Patentamt

European Patent Office

Office européen des brevets

(19)

(11) Veröffentlichungsnummer: **0 211 358**

**A1**

(12) **EUROPÄISCHE PATENTANMELDUNG**

(21) Anmeldenummer: 86110308.3

(22) Anmeldetag: 25.07.86

(51) Int. Cl.⁴ **G11C 29/00** , G06F 11/10

(30) Priorität: 29.07.85 DE 3527108

(43) Veröffentlichungstag der Anmeldung:
25.02.87 Patentblatt 87/09

(84) Benannte Vertragsstaaten:
AT BE CH DE FR GB IT LI NL SE

(71) Anmelder: **Siemens Aktiengesellschaft Berlin und München**
**Wittelsbacherplatz 2**
**D-8000 München 2(DE)**

(72) Erfinder: **Kaiserswerth, Rudolf, Dipl.-Ing.**
**Leitzacherstrasse 6/1**
**D-8000 München 90(DE)**
Erfinder: **Walters, Philip, Dipl.-Ing.**
**Quiddestrasse 78**
**D-8000 München 83(DE)**

(54) Verfahren zur Überwachung von Halbleiterspeichern mit Einrichtungen zur Sicherung gespeicherter Daten und nach diesem Verfahren arbeitende Speichersteuereinrichtungen für Halbleiterspeicher.

(57) Erleichterung der Feststellung der Fehlerursachen von Speicherfehlern durch Abwandlung aller Schreibbefehle in kombinierte Schreib-/Lesebefehle abhängig von einem wahlweise wirksam schaltbaren Steuersignal (PL-MOD) und Erfassung der während eines solchen kombinierten Schreib-/Lesevorganges anfallenden Informationen und Signalzustände durch eine Prüf-und Meßeinrichtung (FREG-E) mit bleibender Aufzeichnung beim Vorliegen nicht korrigierbarer Lesedaten, wobei die während des Lesevorganges normalersweise ausgelösten Schnittstellensignale -(DARDY) bzw. (RHARDER) unterdrückt werden und gegebenenfalls das eine nicht ausführbare. Schreibanforderung kennzeichnende Signal (WHARDER) gesendet wird.

FIG 1

EP 0 211 358 A1

## Verfahren zur Überwachung von Halbleiterspeichern mit Einrichtungen zur Sicherung gespeicherter Daten und nach diesem Verfahren arbeitende Speichersteuereinrichtungen für Halbleiterspeicher

Die Erfindung betrifft ein Verfahren gemäß dem Oberbegriff des Patentanspruches 1 und nach diesem Verfahren arbeitende Speichersteuereinrichtungen für Halbleiterspeicher.

Halbleiterspeicher mit großer Speicherungsdichte finden vor allem in Datenverarbeitungsanlagen in zunehmendem Maße Verwendung. Mit steigender Speicherungsdichte vergrößert sich zwangsläufig die Gefahr, daß Fehler verschiedenster Art beim Betrieb des Speichers auftreten -man siehe Electronic Design, 18. Februar 1982, Seiten 177 bis 186. Aus diesem Grunde werden Halbleiterspeicher vor der Produktionsfreigabe vielfältigen Prüfungen und Messungen unterzogen, um die jeweils günstigsten Schaltungs-und Betriebsparameter zu ermitteln. Außerdem werden die Speicherdaten zusätzlich gesichert und Korrektureinrichtungen vorgesehen, die aus dem Speicher gelesene Daten notfalls korrigieren.

Bei den Prüfungen lassen sich Fehlerursachen von auftretenden Fehlern in der Regel dann problemlos mit den zur Verfügung stehenden Prüfgeräten eingrenzen und ermitteln, wenn ein Fehler unmittelbar zum Zeitpunkt seines Auftretens als solcher erkannt wird. Schwieriger und wesentlich zeitaufwendiger gestaltet sich dagegen die Suche nach den Fehlerursachen, wenn ein Fehler erst unbestimmte Zeit nach seiner Verursachung erkannt wird, zum Beispiel wenn fehlerfrei angelieferte Daten beim Abspeichern aus irgendeinem Grunde verfälscht werden und der dadurch bedingte Fehler erst später beim Lesen dieser Daten durch die Fehlererkennungs-und Korrektureinrichtungen als nicht korrigierbar erkannt wird. In diesem Fall ist im Nachhinein ein Rückschluß auf die mögliche Fehlerursache zum Schreibzeitpunkt nicht mehr möglich, und die Fehlerursache muß auf anderem Wege, in der Regel in Verbindung mit verschärften Prüfbedingungen und zeitweiliger Aufzeichnung der einzelnen Schaltvorgänge, aufgespürt werden.

Aufgabe der Erfindung ist es daher, eine Lösung zu finden, die es ermöglicht, den Aufwand für das Auffinden von Fehlerursachen bei normalerweise erst im Nachhinein erkennbaren oder sehr selten auftretenden Fehlern zu verringern, indem Fehlerquellen schnell erkannt und gezielter beseitigt werden können, ohne daß dadurch die Schnittstellenfunktionen zwischen Speicher und vorgeordneter Steuereinheit beeinträchtigt werden.

Diese Aufgabe wird in allgemeiner Form durch das Verfahren gemäß der Erfindung entsprechend den kennzeichnenden Merkmalen des Patentanspruches 1 gelöst. Danach wird durch ein gesondertes Steuersignal jeder auftretende Schreibbefehl in einen kombinierten Schreib-/Lesebefehl abgewandelt und es werden demzufolge die jeweils angelieferten Daten nicht nur in den Speicher eingeschrieben, sondern daran anschließend jedesmal auch sofort wieder ausgelesen und auf ihre Richtigkeit bzw. Korrigierbarkeit überprüft. Nicht korrigierbare Fehlfunktionen des Speichers werden daher unmittelbar und nicht erst nach unbestimmter Zeit erkannt, so daß sich die Fehlerursachen viel einfacher und mit wesentlich geringerem Aufwand als bisher ermitteln lassen. Damit der mit dem Einschreiben jeweils gekoppelte Lesevorgang nicht die sonst üblichen Schnittstellensignale, nämlich das Gültigkeitssignal oder das Lesefehlersignal, auslöst, werden diese von der Speichersteuereinrichtung unterdrückt und im Fehlerfall das die Nichtausführbarkeit der Schreibanforderung anzeigende Schreibfehlersignal ausgelöst. Die bestehenden Schnittstellenfunktionen bleiben dadurch unbeeinträchtigt, so daß eine Prüfung des Speichers mit seiner Speichersteuereinrichtung unter normalen Betriebsbedingungen durchgeführt werden kann.

Das gesonderte Steuersignal kann wahlweise, z.B. von Hand, allein zu Prüfzwecken wirksam geschaltet werden. Es kann aber auch selbsttätig bei Auftreten eines nicht korrigierbaren Lesefehlers während des normalen Betriebes ausgelöst werden. Voraussetzung ist im letzteren Falle, daß auch im normalen Betrieb eine Meß-und Aufzeichnungseinrichtung mit der Speichersteuereinrichtung und dem Speicher gekoppelt ist, um die notwendigen Informationen und Signalzustände zu erfassen und gegebenenfalls aufzuzeichnen, wenn eine Schreibanforderung zu nicht korrigierbaren Lesedaten führt.

Eine Speichersteuereinrichtung gemäß der Erfindung ergibt sich aus den kennzeichnenden Merkmalen des Patentanspruches 5. Danach ist der zusätzliche Aufwand für die Durchführung des erfindungsgemäßen Verfahrens äußerst gering. Erforderlich sind lediglich Einrichtungen zur Auswertung des gesonderten Steuersignales, Einrichtungen zur Abwandlung jedes Schreibbefehles in einen kombinierten Schreib-/Lesebefehl sowie Einrichtungen zur Unterdrückung der im Rahmen des Lesevorganges normalerweise anfallenden Schnittstellensignale und zur Auslösung des gegebenenfalls notwendigen Fehlersignals zur Quittierung einer nicht zum Erfolg führenden Schreibanforderung. Weiterbildungen entsprechend den verschiedenen Verfahrensvarianten gemäß der Erfindung ergeben sich aus den Ansprüchen 6 und 7.

Die benötigten Einrichtungen können bei Ausführung in festverdrahteter Logik durch Einfügen von entsprechenden Verknüpfungsgliedern in die vorhandene Speichersteuereinrichtung in einfacher Weise realisiert werden, während bei einer speicherprogrammierten Logik entsprechende Verzweigungen im Ablaufprogramm die jeweils notwendigen Funktionen auslösen.

In beiden Fällen kann der vorhandene Steuerungsablauf für den Lesevorgang entweder für den kombinierten Schreib-/Lesebefehl mit ausgenutzt werden, oder aber es werden getrennte Steuerungsabläufe für die verschiedenen drei Speicherbefehle Lesen, Schreiben und kombiniertes Schreiben/Lesen vorgesehen, wobei durch eine vorausgehende Prüfung der jeweils auszuführende Steuerungsablauf festgelegt wird. Auf diese zuletzt genannte Lösungsvariante beziehen sich die weiteren Ansprüche 8 bis 10.

Einzelheiten der Erfindung seien nachfolgend anhand von in der Zeichnung dargestellten Ausführungsbeispielen näher erläutert. Im einzelnen zeigen

FIG 1 ein Übersichtsschaltbild eines Halbleiterspeichers mit Speichersteuereinrichtung und Schnittstelle für eine mit dem Speicher zusammenarbeitende Steuereinheit,

FIG 2 ein allgemeines Flußdiagramm für die Speichersteuereinrichtung von FIG 1,

FIG 3 eine Prüfsteuerschaltung zur Ermittlung des jeweils benötigten Steuerungsablaufs innerhalb der Speichersteuereinrichtung von FIG 1 und

FIG 4 eine weitere Prüfsteuerschaltung entsprechend der von FIG 3 für eine speicherprogrammierte Ablaufsteuerung mit unmittelbarer Adressierung.

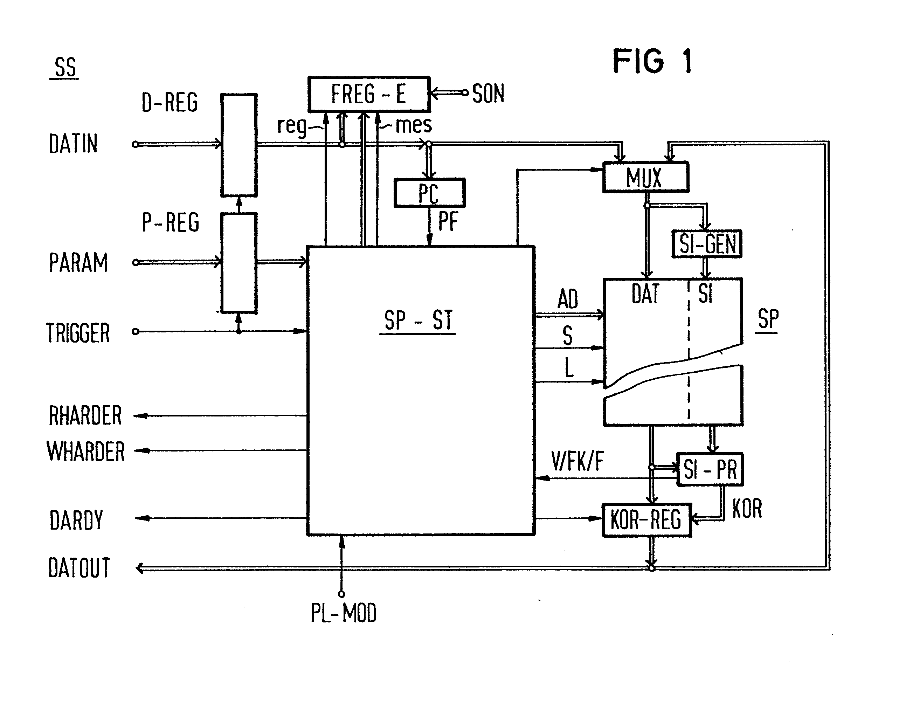

FIG 1 zeigt ein über die Schnittstelle SS mit einer nicht dargestellten Steuereinheit, z.B. Prozessoreinheit einer Datenverarbeitungsanlage, verbundene Speichereinheit, bestehend aus dem Speicher SP und der Speichersteuereinrichtung SP-ST sowie zwei Registern D-REG und P-REG für die Eingabedaten DATIN und die zugehörigen Parameterdaten PARAM. Die Dateneingabe in den Speicher SP erfolgt über einen Multiplexer MUX vom Datenregister D-REG oder vom Ausgang des Speichers aus. An den Ausgang des Multiplexers MUX ist ein Sicherungszeichengenerator SI-GEN angeschlossen, der parallel zu den im Speicher SP abzuspeichernden Daten DAT das jeweils zugehörige Sicherungszeichen SI liefert, das auf an sich bekannte Weise erzeugt wird und eine Korrektur gelesener Daten im Fehlerfall in einem vorgegebenen Ausmaß ermöglicht.

Bei jedem Lesevorgang wird das jeweils zugehörige Sicherungszeichen SI ebenfalls gelesen und einer Überwachungsschaltung SI-PR zugeführt, die aus den gelesenen Daten DAT in an sich bekannter Weise erneut ein Sicherungszeichen bildet, dieses mit dem gelesenen Sicherungszeichen vergleicht und daraus die notwendigen Steuer-und Korrektursignale ableitet. Fehlerfreie Lesedaten werden dabei durch das Steuersignal V, korrigierbare Lesedaten durch das Steuersignal FK und nicht korrigierbare Lesedaten durch das Steuersignal F gekennzeichnet. Bei korrigierbaren Lesedaten liefern die Korrektursignale KOR die notwendigen Korrekturhinweise, anhand derer die im Korrekturregister KOR-REG zwischengespeicherten Lesedaten gegebenenfalls korrigiert werden, bevor sie durch die Speichersteuereinrichtung SP-ST mit dem Gültigkeitssignal DARDY als Ausgabedaten DATOUT an der Schnittstelle SS freigegeben werden. Ist der Fehler dagegen nicht korrigierbar, wird dies über die Schnittstelle SS mit RHARDER signalisiert.

Anforderungen an das Speichersystem werden durch das Schnittstellensignal TRIGGER wirksam, das gleichzeitig die Übernahme der Anforderungsinformationen PARAM/DATIN in die Eingangspufferregister P-REG bei einer Leseanforderung und zusätzlich D-REG bei einer Schreibanforderung steuert. Mit dem Ausgang des Dateneingaberegisters D-REG ist eine Paritätskontrollschaltung PC verbunden, die im Fehlerfall ein Fehlersignal PF liefert, das in an sich bekannter Weise zur sofortigen Abweisung der Schreibanforderung mit dem Schnittstellensignal WHARDER führt.

Welche Art von Anforderung jeweils vorliegt, ermittelt die Speichersteuereinrichtung SP-ST aus dem Befehlsteil der Parameterdaten PARAM, die gleichfalls die anzusteuernde Adresse AD für den Speicher SP liefern. Nach Decodierung des Befehlsteiles wird dann entweder der durch die Adresse AD ausgewählte Speicherabschnitt des Speichers SP beim Signal L gelesen, oder aber beim Signal S mit den bereitstehenden Eingabedaten überschrieben.

Zusätzlich ist für Prüfzwecke eine Prüf-und Meßeinrichtung FREG-E in an sich bekannter Weise mit der Speichersteuereinrichtung SP-ST und mit verschiedenen Daten-und Signalpfaden des Speichersystems verbunden, so daß Informationen und Signalzustände während der einzelnen Phasen des Steuerungsablaufes erfaßt und gegebenenfalls aufgezeichnet werden können, so daß sie für die Feststellung der Fehlerursache verfügbar sind. Im vorliegenden Falle sind nur die Verbindungen mit der Speichersteuereinrichtung SP-ST und dem Eingabedatenpfad gezeigt, während alle übrigen Verbindungen global mit dem Anschluß SON angedeutet sind, da dies für das Verständnis der Erfindung ohne Bedeutung ist. Von den beiden weiteren Steueranschlüssen mes und reg löst der erste die Erfassung aus und der zweite entscheidet darüber, ob die erfaßten Informationen und Signalzustände tatsächlich registriert werden sollen.

In Auswirkung der Erfindung weist die Speichersteuereinrichtung SP-ST den weiteren Steuereingang PL-MOD auf, der darüber entscheidet, ob ein Schreibbefehl als solcher ausgeführt oder in einen kombinierten Schreib-/Lesebefehl abgewandelt werden soll und ob die Prüf-und Meßeinrichtung FREG-E wirksam werden soll oder nicht.

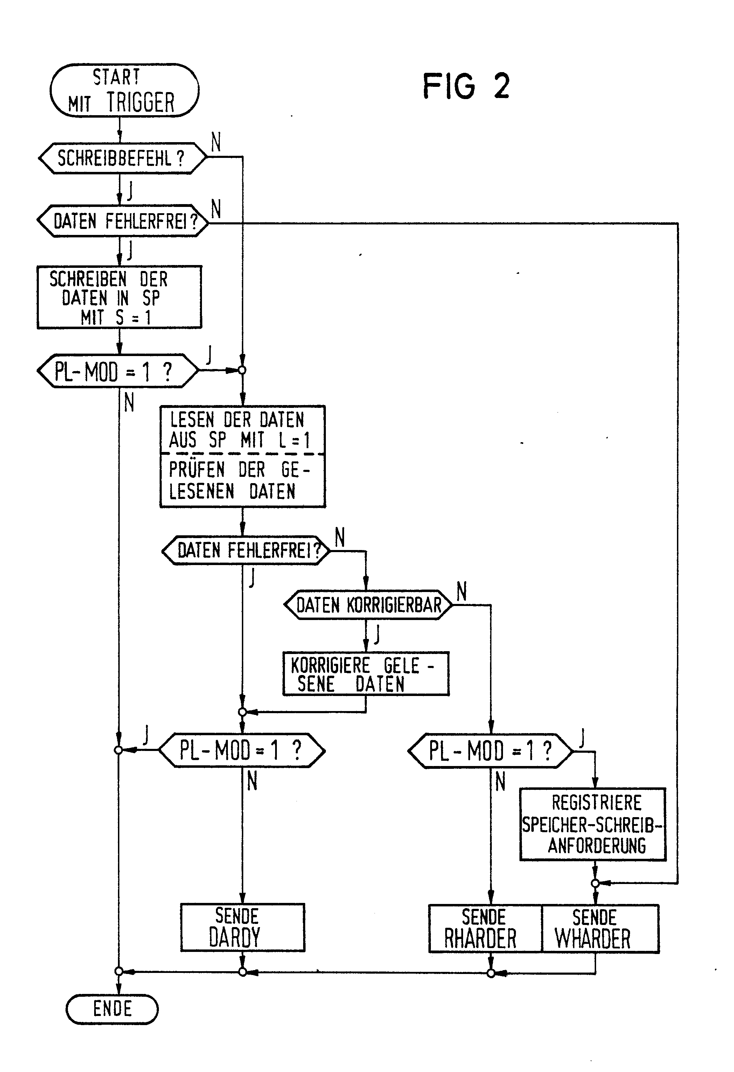

Die durch das Steuersignal PL-MOD gemäß der Erfindung beeinflußte Arbeitsweise der Speichersteuereinrichtung SP-ST ergibt sich aus dem Flußdiagramm von FIG 2.

Beginnend mit dem eine Speicheranforderung kennzeichnenden Schnittstellensignal TRIGGER, wird zunächst geprüft, ob ein Schreibbefehl vorliegt oder nicht. Sind bei einem Schreibbefehl die angelieferten Daten fehlerfrei (PF = 0 in FIG 1), dann wird in üblicher Weise der Schreibvorgang ausgelöst und ausgeführt, während bei fehlerbehafteten Eingabedaten DATIN das Schnittstellensignal WHARDER ausgelöst wird. Die Schreibanforderung ist damit norma lerweise erledigt.

Analoges gilt für eine Leseanforderung, die nach der Befehlscodierung zur Ausführung des Lesevorganges führt. Die gelesenen Daten werden anschließend überprüft, und abhängig von den Steuersignalen V,FK bzw. F der Prüfeinrichtung SI-PR in FIG 1 wird dann bei fehlerfreien Lesedaten - (Steuersignal V = 1) bzw. bei fehlerbehafteten, aber korrigierbaren Lesedaten (Steuersignal FK = 1) nach deren Korrektur normalerweise das Gültigkeitssignal DARDY ausgelöst, während bei fehlerbehafteten und nicht korrigierbaren Lesedaten (Steuersignal F = 1) normalerweise das Schnittstellensignal RHARDER gesendet wird.

Ist dagegen das gesonderte Steuersignal PL-MOD wirksam geschaltet, dann wird nach dem Schreibvorgang zusätzlich auch ein Lesevorgang für die gerade eingeschriebenen Daten ausgelöst. Weiterhin wird bei Vorliegen fehlerfreier oder korrigierbarer Lesedaten die Aussendung des gültigkeitssignals DARDY unterdrückt, während bei nicht korrigierbaren Lesedaten statt des Schnittstellensignals RHARDER das Schnittstellensignal WHARDER zur Kennzeichnung einer nicht erfolgreich ausführbaren Schreibanforderung ausgelöst wird. Weiterhin werden aufgrund des wirksamen Steuersignals mes während jedes kombinierten Schreib-/Lesevorganges die anfallenden Informationen und Signalzustände von der Prüf-und Meßeinrichtung FREG-E erfaßt und mit einem vom Fehlersignal F = 1 abgeleiteten Steuersignal reg gegebenenfalls aufgezeichnet, damit sie für die Ermittlung der Fehlerursache verfügbar sind.

Im vorliegenden Falle führt also das zusätzliche Steuersignal PL-MOD zu drei möglichen Ablaufverzweigungen im bisherigen Steuerungsablauf, wobei der Steuerungsablauf für den Lesevorgang in die Ausführung des kombinierten Schreib-/Lesebefehles einbezogen ist. Bei einer fest verdrahteten Ablaufsteuerung kann die jeweilige Umsteuerung in einfacher Weise durch an entsprechender Stelle eingefügte einfache Verknüpfungsglieder und bei einer speicherprogrammierten Ablaufsteuerung durch entsprechende bedingte Sprungbefehle bewirkt werden.

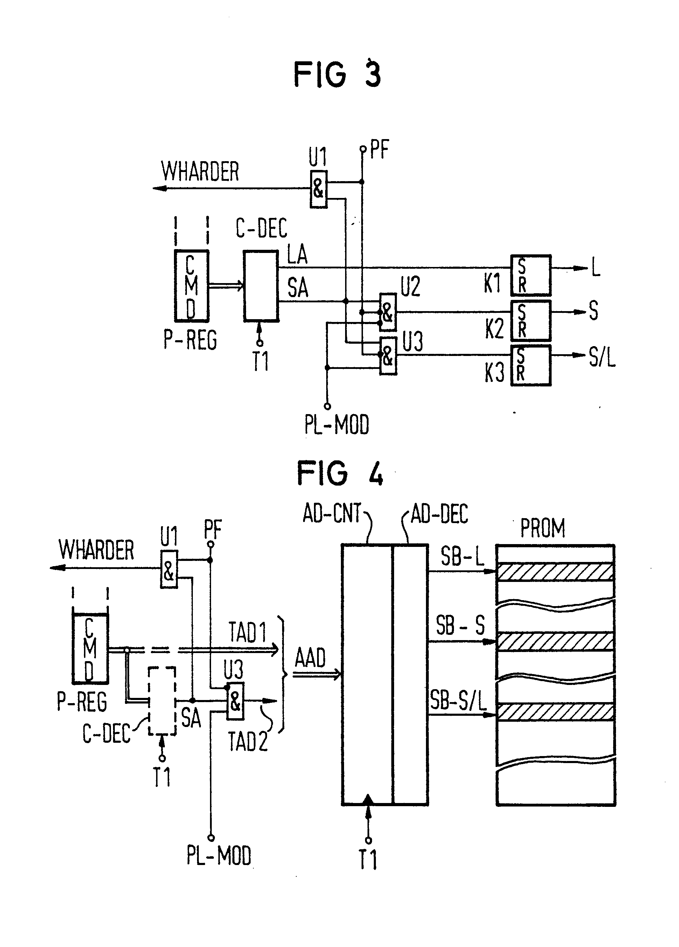

Es ist aber auch ohne weiteres möglich, die notwendige Umsteuerung im Anschluß an die Befehlsdecodierung nur einmal vorzunehmen und für die Ausführung der drei verschiedenen Speicherbefehle Lesen, Schreiben und kombibiniertes Schreiben/Lesen drei voneinander unabhängige Steuerungsabläufe einzuleiten. Dieses Prinzip liegt den Ausführungsbeispielen von FIG 3 und FIG 4 zugrunde.

Bei der Lösungsvariante nach FIG 3 wird der im Parameterregister P-REG von FIG 1 enthaltene Befehlsteil CMD durch einen Decodierer DEC mit einem vom Schnittstellensignal TRIGGER abgeleiteten Steuerimpuls T1 überprüft und ermittelt, ob eine Schreib-oder eine Leseanforderung SA bzw. LA vorliegt. Bei einer Schreibanforderung SA wird abhängig vom Paritätsfehlersignal PF für die Eingabedaten DATIN über das UND-Glied U1 entweder das Schnittstellensignal WHARDER ausgelöst, oder aber es werden die Steuergatter U2 und U3 freigegeben, von denen jeweils eines abhängig vom Steuersignal PL-MOD durchgesteuert wird, so daß die Auslösekippstufe K2 für den reinen Schreibvorgang oder K3 für den kombinierten Schreib-/Lesevorgang gesetzt wird. Bei einer Leseanforderung LA wird dagegen die Auslösekippstufe K1 für einen reinen Lesevorgang direkt gesetzt. Die weiteren Steuerungsabläufe können dann fest verdrahtet oder speicherprogrammiert festgelegt sein.

Bei der allein auf eine speicherprogrammierte Ablaufsteuerung abgestellten Lösungsvariante nach FIG 4 wird dagegen der Befehlsteil CMD im Parameterregister P-REG unmittelbar für die Bildung einer Ansteueradresse zum Aufruf eines Ablaufprogrammes in einem Mikrobefehlsspeicher PROM genutzt. Damit dabei abhängig vom Steuersignal PL-MOD bei einer Schreibanforderung SA zwei verschiedene Mikroprogramme gestartet werden können, nämlich eines für normales Schreiben S und eines für kombiniertes Schreiben/Lesen S/L, bildet der Befehlsteil CMD nur eine erste Teiladresse TAD1, die durch ein Adressenbit als zweiter Adressenteil TAD2 ergänzt wird. Dieses Adressenbit wird lediglich dann zu "1", wenn eine Schreibanforderung SA vorliegt, was entweder direkt anhand eines signifikanten Bits im Befehlsteil CMD erkannt oder aber durch einen Befehlsdecodierer C-DEC ermittelt werden kann, und wenn gleichzeitig das Steuersignal PL-MOD in Verbindung mit fehlerfreien Eingabedaten (PF = 0) wirksam ist. Die Erfüllung dieser Dreifachbedingung wird mit dem UND-Glied U3 überwacht.

Mit einem nach Wirksamwerden des Schnittestellensignals TRIGGER auftretenden Steuerimpuls T1 wird daher zunächst das Adressenbit am Ausgang des UND-Gliedes U3 ermittelt und dann, zum Beispiel mit der Rückflanke des Steuerimpulses T1 oder einem weiteren Steuerimpuls, die dadurch bedingte Anfangsadresse AAD in einen Adressenzähler AD-CNT geladen, dessen Ausgänge über einen Adressendecoder AD-DEC den jeweiligen Startbefehl, z.B. SB-L, des den einzelnen Steuerungsabläufen zugeordneten Mikroprogrammes auswählen. Nach dem Start des ausgewählten Mikroprogrammes wird dann in an sich bekannter Weise der Adressenzähler AD-CNT entweder - schrittweise oder bei notwendigen Verzweigungen, die dann aber nicht mehr vom Steuersignal PL-MOD abhängig sind, um mehrere Schritte fortgeschaltet.

Bei den Ausführungsbeispielen von FIG 3 und FIG 4 arbeiten also die die Befehlsart feststellenden sowie die das Fehlersignal PF und das Steuersignal PL-MOD auswertenden Einrichtungen in Form einer Prüfsteuerschaltung zusammen, die den weiteren Steuerungsablauf bestimmt.

## Ansprüche

1. Verfahren zur Überwachung von Halbleiterspeichern mit Einrichtungen zur Sicherung gespeicherter Daten und zur Korrektur gelesener, fehlerbehafteter Daten in Verbindung mit einer Speichersteuereinrichtung zur Steuerung der Schreib-und Lesevorgänge, wobei die Speichersteuereinrichtung von einer mit dem Halbleiterspeicher zusammenarbeitenden Steuereinheit, z.B. Prozessor einer Datenverarbeitungsanlage, Speicheranforderungen zum Schreiben oder Lesen von Daten entgegennimmt und wegen Vorliegen fehlerbehafteter Daten nicht ausführbare Speicheranforderungen durch ein entsprechendes Fehlersignal quittiert, während bei Leseanforderungen gültige Daten durch ein Gültigkeitssignal gekennzeichnet werden, **dadurch gekennzeichnet**, daß abhängig von einem gesonderten Steuersignal (PL-MOD) in den Speicher - (SP) eingeschriebene Daten anschließend sofort gelesen und auf Fehlerfreiheit überprüft werden und daß bei Vorliegen fehlerfreier oder fehlerbehafteter, aber korrigierbarer Lesedaten das infolge des Lesevorganges normalerweise ausgesandte Gültigkeitssignal unterdrückt wird, während bei fehlerbehafteten, nicht korrigierbaren Lesedaten anstelle des einer Leseanforderung zugeordneten Fehlersignales (RHARDER) das der Schreibanforderung zugeordnete Fehlersignal (WHARDER) wirksam geschaltet wird.

2. Verfahren nach Anspruch 1, **dadurch gekennzeichnet**, daß das gesonderte Steuersignal - (PL-MOD) wahlweise wirksam geschaltet wird.

3. Verfahren nach Anspruch 2, **dadurch gekennzeichnet**, daß das gesonderte Steuersignal - (PL-MOD) selbsttätig durch einen im Rahmen einer Leseanforderung erkannten nicht korrigierbaren Fehler wirksam geschaltet wird.

4. Verfahren nach einem der Ansprüche 1 bis 3, **dadurch gekennzeichnet**, daß bei wirksam geschaltetem Steuersignal (PL-MOD) mit jeder Schreibanforderung die für ein Auffinden der Fehlerursachen in Frage kommenden Informationen und Signalzustände im Laufe des ausgelösten kombinierten Schreib/Lesevorganges erfaßt und bei anschließendem Auftreten eines nicht korrigierbaren Speicherlesefehlers endgültig aufgezeichnet werden.

5. Speichersteuereinrichtung zur Durchführung der Verfahren nach einem der Ansprüche 1 bis 4, **gekennzeichnet** durch Einrichtungen zur Auswertung des gesonderten Steuersignales (PL-MOD), durch Einrichtungen zur Umwandlung eines auftretenden Schreibbefehls in einen kombinierten Schreib-/Lesebefehl bei Vorliegen des gesonderten Steuersignals (PL-MOD) und durch mit den Sicherungs-und Korrektureinrichtungen (SI-PR) des Halbleiterspeichers (SP) gekoppelten Einrichtungen zur Unterdrückung des Gültigkeitszeichens - (DARDY) bei fehlerfreien oder korrigierbaren Lesedaten und zur Auslösung des eine Schreibanforderung quittierenden Fehlersignals (WHARDER) anstelle des eine Leseanforderung quittierenden Fehlersignales (RHARDER) bei nicht korrigierbaren Lesedaten im Rahmen eines durch das gesonderte Steuersignal (PL-MOD) ausgelösten kombinierten Schreib/Lesevorganges.

6. Speichersteuereinrichtung nach Anspruch 5, **gekennzeichnet** durch ein Steuerschaltglied zur Wirksamschaltung des gesonderten Steuersignales (PL-MOD) beim Auftreten nicht korrigierbarer Lesedaten im normalen Betrieb.

7. Speichersteuereinrichtung nach Anspruch 5 oder 6, **gekennzeichnet** durch eine mit der Speichersteuereinrichtung (SP-ST) und den Daten-und Signalpfaden des Halbleiterspeichers (SP) gekoppelte Prüf-und Meßeinrichtung (FREG-E) zur Erfassung der für ein Auffinden der Fehlerursachen notwendigen Informationen und Signalzustände im Laufe eines abhängig vom gesonderten Steuersignal (PL-MOD) ausgelösten kombinierten Schreib-/Lesevorganges und zur endgültigen Aufzeichnung der erfaßten Informationen und Signalzustände abhängig vom anschließenden Auftreten eines nicht korrigierbaren Speicherlesefehlers.

8. Speichersteuereinrichtung nach einem der Ansprüche 5 bis 7, **dadurch gekennzeichnet**, daß die Einrichtungen zur Auswertung des gesonderten Steuersignales (PL-MOD) zusammen mit Einrichtungen zur Feststellung der jeweiligen Befehlsart und zur Auswertung des die Fehlerfreiheit der jeweils zu schreibenden Daten anzeigenden Steuersignales (PF = 0) eine Prüfsteuerschaltung bilden, die den weiteren Arbeitsablauf der Speichersteuereinrichtung (SP-ST) bestimmt, nämlich Einleiten eines Lesevorganges (L) oder Aussenden des eine Schreibanforderung (SA) quittierenden Fehlersignales (WHARDER) oder Einleiten eines Schreibvorganges (S) oder Einleiten eines kombinierten Schreib-/Lesevorganges (S/L).

9. Speichersteuereinrichtung nach Anspruch 8, **dadurch gekennzeichnet**, daß für die Steuerung der drei Speicherarbeitsabläufe Lesen (L) Schreiben (S) oder kombiniertes Schreiben/Lesen (S/L) eine speicherprogrammierte Steuerung mit entsprechenden Ablaufprogrammen vorgesehen ist, von denen das jeweils auszuführende Ablaufprogramm von der Prüfsteuerschaltung aufgerufen wird.

10. Speichersteuereinrichtung nach Anspruch 9, **dadurch gekennzeichnet**, daß die Prüfsteuerschaltung als Adressengenerator für einen unmittelbar adressierbaren Mikroprogrammspeicher (PROM) ausgebildet ist, der die jeweils durch eine gesonderte Anfangsadresse (AAD) gekennzeichneten Ablaufprogramme gespeichert enthält, und daß die Anfangsadressen (AAD) jeweils aus dem vorliegenden Speicherbefehl (CMD) als erstem Adressenteil (TAD1) und einem gesonderten Adressenbit als zweitem Adressenteil (TAD2) gebildet wird, wobei das gesonderte Adressenbit nur bei einem auszuführenden kombinierten Schreib-/Lesebefehl gesetzt wird.

FIG 1

# FIG 2

START MIT TRIGGER

SCHREIBBEFEHL ? — N / J

DATEN FEHLERFREI? — N / J

SCHREIBEN DER DATEN IN SP MIT S = 1

PL-MOD = 1 ? — J / N

LESEN DER DATEN AUS SP MIT L = 1
------
PRÜFEN DER GE-LESENEN DATEN

DATEN FEHLERFREI? — N / J

DATEN KORRIGIERBAR — N / J

KORRIGIERE GELE-SENE DATEN

PL-MOD = 1 ? — J / N

PL-MOD = 1 ? — N / J

REGISTRIERE SPEICHER-SCHREIB-ANFORDERUNG

SENDE DARDY

SENDE RHARDER

SENDE WHARDER

ENDE

# FIG 3

# FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 319 356  (KOCOL) <br> * Zusammenfassung; Spalte 3, Zeile 65 - Spalte 4, Zeile 14; Spalte 4, Zeile 63 - Spalte 5, Zeile 51; Spalte 6, Zeilen 33-39; Figuren 2,3 * | 1,3 | G 11 C  29/00 <br> G 06 F  11/10 |
| | --- | | |
| A | US-A-3 735 105  (MALEY) <br> * Seite 2, Zeilen 20-64; Seite 4, Zeile 29 - Seite 5, Zeile 55; Figuren 1,2 * | 1,3,4 | |
| | --- | | |
| A | US-A-3 898 449  (SANABRIA) <br> * Zusammenfassung; Seite 11, Zeilen 1-31 * | 1-2 | |
| | --- | | |
| A | US-A-3 863 227  (SANABRIA) <br> * Seite 1, Zeilen 4-10; Seite 19 - Seite 20, Zeile 68; Figur 7 * | 1-2,4 | **RECHERCHIERTE SACHGEBIETE (Int. Cl.4)** |
| | --- | | G 11 C  29/00 <br> G 06 F  11/10 |
| A | US-A-4 360 915  (SINDELAR) <br> * Seite 3, Zeile 34 - Seite 4, Zeile 7; Seite 7, Zeilen 24-50; Seite 8, Zeilen 4-13; Figuren 1,2 * | 1,3 | G 06 F  11/00 <br> G 06 F  11/22 |
| | ----- | | |

Der vorliegende Recherchenbericht wurde für alle Patentansprüche erstellt.

| Recherchenort: DEN HAAG | Abschlußdatum der Recherche 11-11-1988 | Prüfer GUIVOL Y. |
|---|---|---|

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein-stimmendes Dokument

EPA Form 1503 03 82